# NEUE EUROPÄISCHE PATENTSCHRIFT

(11) **EP 2 047 287 B2**
(45) Veröffentlichungstag und Bekanntmachung des Hinweises auf die Entscheidung über den Einspruch: **16.04.2014**
(45) Hinweis auf die Patenterteilung: 07.04.2010
(21) Anmeldenummer: 07729004.7
(22) Anmeldetag: 11.05.2007
(51) Int. Cl.: G01R 31/00, B60T 8/36

(54) **VERFAHREN UND PULSWEITENMODULIERTE STROMREGELSCHALTUNG ZUR ANSTEUERUNG VON INDUKTIVEN LASTEN IN KRAFTFAHRZEUGEN**
METHOD AND PULSE-WIDTH-MODULATED CURRENT CONTROL CIRCUIT FOR DRIVING INDUCTIVE LOADS IN MOTOR VEHICLES
PROCÉDÉ ET CIRCUIT DE RÉGLAGE DE COURANT À MODULATION DE LARGEUR D'IMPULSION POUR LA COMMANDE DE CHARGES INDUCTIVES DANS DES VÉHICULES AUTOMOBILES

(30) Priorität: 17.05.2006 DE 102006023342; 27.07.2006 DE 102006035564
(43) Veröffentlichungstag der Anmeldung: 15.04.2009
(73) Patentinhaber: Continental Teves AG & Co. OHG, 60488 Frankfurt (DE)
(72) Erfinder: JÄGER, Markus, 65760 Eschborn (DE); OEHLER, Peter, 60314 Frankfurt (DE); MICHEL, Frank, 61191 Rosbach V.d.höhe (DE); HEINZ, Micha, 64289 Darmstadt (DE); FEY, Wolfgang, 65527 Niedernhausen (DE); SCHMITZ, Axel, 65795 Hattersheim (DE); JOECKEL, Wolfgang, D-36129 Gersfeld (DE)
(86) Internationale Anmeldenummer: PCT/EP2007/054552
(87) Internationale Veröffentlichungsnummer: WO 2007/131947

(56) Entgegenhaltungen:
- EP-B1- 1 355 804
- WO-A-02/058967
- WO-A-03/039904
- WO-A-2005/009815
- DE-A1- 4 006 298
- DE-A1- 4 109 233
- DE-A1- 10 065 239
- DE-A1- 10 200 771
- DE-A1- 19 915 593
- DE-A1-102004 017 239
- DE-A1-102005 012 752
- Vorbenutzung WABCO "Digiprop Standard" in 1993, 1994, Produktidentifikation Nr. 4461261000
- Vorbenutzung und Datenkennblatt Infineon Smart High-Side Power Switch BTS740S2
- U. TIETZE ET AL: 'Halbleiter-Schaltungstechnik', Bd. 12, Januar 2002, SPRINGER VERLAG, ERLANGEN-MÜNCHEN, ISBN 3-540-42849-6 Seite 1002
- Auszug aus Wikipedia, "Analog-to-Digital Converter", als Nachweis des Fachwissens
- C. BONNIE ET AL: 'Techniques that reduce system noise in ADC circuits' MICROCHIP ADN007 2004, Seiten 1 - 2

## Beschreibung

Die Erfindung betrifft ein Verfahren gemäß Oberbegriff von Anspruch 1, eine Schaltungsanordnung gemäß Oberbegriff von Anspruch 8 sowie deren Verwendung.

Elektronische Kraftfahrzeugsteuergeräte, wie Regler für ABS- und/oder ESP-Kraftfahrzeugbremsensteuergeräte umfassen vielfach redundante Mikroprozessorsysteme und zusätzliche Leistungsschaltkreise zur Ansteuerung von Lasten, wie beispielsweise der zur Druckregelung notwendigen elektromagnetischen Ventilspulen. Moderne elektronische Bremsensteuergeräte für Bremsen umfassen hierzu nur noch eine begrenzte Anzahl von hochintegrierten Bauelementen, in denen die meisten diskreten Bauelemente des Reglers in zwei oder sogar lediglich einem integrierten Bausteinen zusammengefasst sind. Eine heute übliche Integrationsstufe umfasst zwei integrierte Schaltkreise, wobei die Mikrorechnersysteme in einem ersten Bauelement und die Leistungsschaltkreise in einem zweiten, gemischten Analog/Digital-Schaltkreis zusammengefasst werden. Im zweiten integrierten Schaltkreis befindet sich außerdem ein Analog/Digital-Wandler, um die analogen Werte für den Mikrocontroller als Digitalwerte zur Verfügung zu stellen. Aus Kostengründen ist es von Vorteil, einen einzigen A/D-Wandler für mehrere Messungen zu verwenden.

In hochwertigen elektronischen ABS- und ESP-Bremsenregelsystemen werden die Ventilspulen zumindest zum Teil nicht mehr geschaltet, sondern es erfolgt eine analogisierte Ansteuerung mittels einer pulsweitenmodulierten Stromregelung (PWM), welche eine nahezu analoge Ansteuerung der Hydraulikventile zulässt. Hierzu sind mehrkanalige PWM-Treiberstufen vorgesehen, die beispielsweise mittels gegenphasig geschalteter MOS-Transistoren aufgebaut sein können. Um eine kostengünstige und Platz sparende Lösung zu ermöglichen, wird eine solche PWM-Stufe üblicherweise als eine integrierte Schaltung realisiert, zumal für ein komplexes ESP-System neben zahlreicher zusätzlicher Schaltungsteile bis zu acht solcher Stufen vorhanden sein müssen. Ein reiner Analogverstärker zur Ansteuerung einer Ventilspule ist aus Gründen zu hoher Verlustleistung nicht praktikabel.

Die grundsätzliche Vorgehensweise beim Einsatz eines einzigen A/D-Wandlers zur Messung des Iststroms innerhalb einer PWM-Regelung zur Ansteuerung der oben erwähnten Ventilspulen geht aus der WO02/058967 A2 (P 10057) und der WO03/039904 A2 (P 10253) bereits hervor. Gemäß den darin beschriebenen Schaltungsbeispielen wird eine bestimmte Anzahl vom Strommesskanälen entsprechend einer komplexen Prioritätslogik entsprechend einem Zeitscheibenprinzip dem A/D-Wandler zugeordnet, so dass dessen Wandlungskapazität möglichst optimal genutzt werden kann.

Die Anforderungen an die obigen elektronischen Steuergeräte nehmen immer mehr zu, da zusätzliche Funktionen durch das Bremsensteuergerät mit übernommen werden bzw. die Bremssysteme eine verbesserte Regelgüte aufweisen sollen. Einige neuere Regelfunktionen, darunter die Kraftfahrzeuglängsregelung (ACC), welche den Abstand zu einem vorausfahrenden Fahrzeug konstant hält, fordern über die reine Möglichkeit der Einstellung eines analogen Stromes hinaus eine besonders präzise Stromregelung, da geringste Abweichungen vom gewünschten Stromwert spürbare Unterschiede im eingestellten Bremsdruck bewirken, so dass eine präzise ACC-Regelung mit entsprechendem Komfort nicht mehr möglich ist. Bei einer länger andauernden ACC-Regelung können zudem bereits leichte Unterschiede zwischen eingestelltem Druck in Vorder- und Hinterachse zu einem Ausfall der Bremsfunktion einer Achse führen. Insbesondere sollen relativ kleine Ströme im Bereich von etwa 100 bis 400 mA eine hohe Präzision aufweisen, da diese Ströme zum Einstellen kleiner Druckdifferenzen, wie sie für eine Längsregelung typisch sind, benötigt werden.

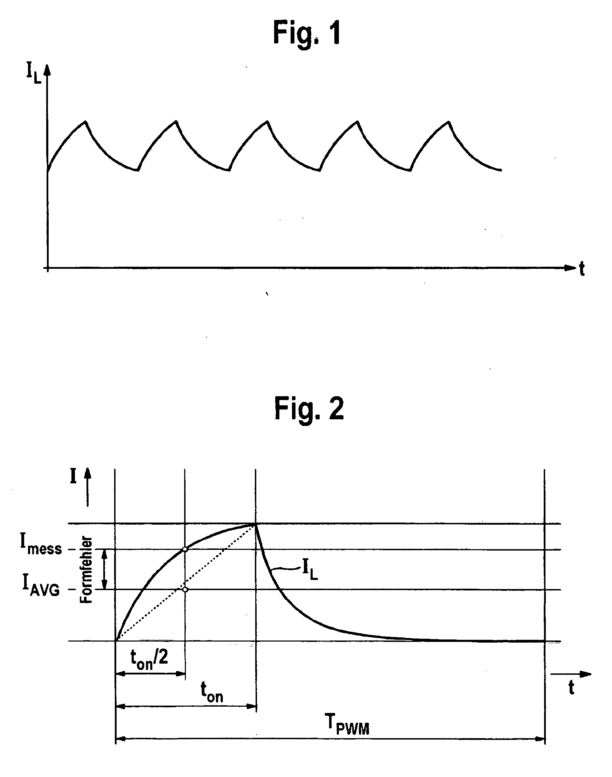

Bei PWM-Stufen, die entsprechend den zuvor genannten Patentanmeldungen WO02/058967 A2 (P 10057) und WO03/039904 A2 (P 10253) ausgeführt sind, besteht daher der Bedarf, die Genauigkeit der PWM-Stromregelung noch weiter zu verbessern. Bei einer PWM-Regelung nach dem genannten Stand der Technik wird im üblichen Anwendungsfall der Bremsenregelung allgemein betrachtet eine induktive Last (z.B. Ventilspule) angesteuert. Die induktive Last besitzt eine bestimmte Induktivität L sowie einen ohmschen Widerstand R. Aus der Induktivität L lässt sich eine Zeitkonstante der Last L/R definieren. Abhängig von dieser Zeitkonstanten und der ansteuernden Frequenz der Pulsweitenmodulation entsteht ein typischer Verlauf des Stromes I_{L} durch die induktive Last über der Zeit t, wie in Fig. 1 gezeigt. Durch den Einsatz eines A/D-Wandlers, welcher mehrfach zur Strommessung in unterschiedlichen PWM-Kanälen genutzt wird, kann nicht an mehreren Punkten des Stromverlaufs in Fig. 1 der Strom bestimmt werden. Die Messung des Stroms erfolgt daher, wie in den oben zitierten Dokumenten beschrieben, zu bestimmten Zeitpunkten (zeitdiskrete Messungen). Der auf diese Weise bestimmte Stromwert weicht je nach Messzeitpunkt beträchtlich vom eigentlich für die PWM-Regelung zu bestimmenden Mittelwert des Stromes ab. Diese Abweichung vom Mittelwert wird im folgenden auch als Formfehler bezeichnet. Wird, wie in Fig. 2 dargestellt, der Stromwert beispielsweise regelmäßig in der Mitte der Einschaltphase zum Zeitpunkt t_{ON}/2 gemessen, entsteht der in Fig. 2 dargestellte Formfehler als Differenz von Mess- zu Mittelwert.

Der Formfehler wird jedoch nicht nur vom Messzeitpunkt der diskreten Strommessung beeinflusst, sondern auch von weiteren Betriebsparametern der PWM-Regelung, wie z.B. der an der Last anliegenden high side-Spannung sowie vom temperaturabhängigen aktuellen ohmschen Widerstand der Last. Insbesondere integrierte Analogschaltungen erreichen nur mit sehr hohem Aufwand eine hohe Absolutgenauigkeit. Zwar ermöglichen beispielsweise an sich bekannte differentielle Schaltungstechniken und an sich bekannte Trimmtechniken eine gewisse Unabhängigkeit gegenüber technologischen Schwankungen und Temperatureffekten, allerdings sind diesen Methoden aufgrund des hohen Aufwands Grenzen gesetzt. Ein Trimmen der Schaltung über die Temperatur würde während der Fertigung einen sehr hohen Zeitaufwand erfordern und ist daher im Hinblick auf eine Fertigung mit hohen Stückzahlen wenig vorteilhaft.

Zur Strommessung wird in den PWM-Stufen gemäß den bereits erwähnten Patentanmeldungen WO02/058967 A2 (P 10057) und WO03/039904 A2 (P 10253) eine Anordnung aus einem Sense-FET in Verbindung mit jeweils zugeordnetem Sense-Verstärker eingesetzt. Der in dieser Anordnung genutzte Sense-FET besitzt typischerweise einen temperaturabhängigen Einschaltwiderstand, welcher zumindest bei Strömen im mA-Bereich in Verbindung mit einem üblicherweise vorhandenen Offsetfehler des Sense-Verstärkers bereits zu einem recht hohen Messfehler führt.

Das in Fig. 2 dargestellte Strommessprinzip erfordert einen Mindestwert für die Einschaltdauer des PWM-Signals, damit in jeder Periode ein Stromwert unter allen Randbedingungen erfasst werden kann. Die Folge dieses Mindestwerts ist, dass sich abhängig vom ohmschen Widerstand der Spule, der high side-Spannung an der Induktivität und der eingestellten PWM-Frequenz ein minimaler Strom ergibt, unterhalb dessen keine Regelung mehr möglich ist. Im typischen Anwendungsfall einer ACC-Regelung für Kraftfahrzeuge lassen sich so beispielsweise nur Ströme bis minimal 200 mA einregeln. ACC-optimierte Strom-Bremsdruck-Kennlinien einer Ventilspule erfordern aber zumeist kleinere Ströme bis hinab zu etwa 100 mA.

Die Auflösung eines PWM-Stromreglers bestimmt, mit welchen Genauigkeitsstufen Ströme eingestellt werden können. Diese hängt im wesentlichen vom maximal einzustellenden Strom sowie von der Auflösung des zur Messung des Stromistwerts vorgesehenen A/D-Wandlers ab.

Die Aufgabe der vorliegenden Erfindung besteht nun darin, ein Verfahren und eine Schaltungsanordnung zur PWM-Stromregelung anzugeben, mit dem eine genauere und sicherere Stromeinstellung vorgenommen werden kann.

Diese Aufgabe wird erfindungsgemäß gelöst durch das Verfahren gemäß Anspruch 1.

Im erfindungsgemäßen Verfahren wird eine Strommessung innerhalb einer integrierten PWM-Regelungsschaltung mittels zumindest einem A/D-Wandler durchgeführt, welcher ebenfalls in der Schaltung integriert ist. Dabei wandelt der A/D-Wandler einen elektrischen Wert, welcher zuvor vorzugsweise mit mindestens einem Strommesselement (z.B. Widerstand) bestimmt worden ist. Vor dem Ermitteln des Iststroms der PWM-Regelung, welcher mit Hilfe des zumindest einen A/D-Wandler bestimmt wird, wird der Strom mittels eines Tiefpasses geglättet. Hierbei ist es vorgesehen, dass die obere Grenzfrequenz des Tiefpasses oder dessen Zeitkonstante veränderbar ist und diese in Abhängigkeit des PWM-Sollstroms oder der PWM-Sollstromänderung verändert wird. Durch Glättung des Stromsignals oder eines einem bestimmten Strom entsprechenden Spannungssignals ist der Zeitpunkt einer A/D-Wandlung weitestgehend unabhängig von der aktuellen Lage innerhalb einer PWM-Periode. Die Glättung des Stromssignals kann entweder im analogen Signalteil oder im digitalen Signalteil des Strommesspfades stattfinden.

Zur Glättung kann bevorzugt ein analoger Tiefpass oder eine Digitalschaltung eingesetzt werden, die wie ein Tiefpass wirkt.

Nach einer bevorzugten Ausführungsform des Verfahrens wird eine Autokalibrierung der integrierten Schaltung durchgeführt, bei der Korrekturwerte für den Strom ermittelt und zur Korrektur des Stroms verwendet werden. Hierdurch kann eine auf Grund der üblicherweise bei elektronischen Bauelementen und insbesondere auch bei integrierten Analogkomponenten begrenzten Absolutgenauigkeit bezüglich des Strommesswertes noch weiter erhöht werden. Gemäß dem Verfahren der Autokalibrierung wird bevorzugt ein kontinuierlicher Abgleich der Schaltung durchgeführt. Dieser Abgleich kann so ausgeführt werden, dass neben Offsetfehlern, welche Langzeitfehler sind, auch Kurzzeiteffekte, wie Temperatur- und Spannungsschwankungen ausgeglichen werden.

Nach einer ersten bevorzugten Ausführungsform eines Autokalibrierungsverfahrens wird die Einstellung des Stroms unter Zuhilfenahme einer digitalen Korrektur der Sollstromanforderung vorgenommen.

Die Korrekturwerte umfassen bevorzugt Offsetwerte und Verstärkungsfaktoren.

Die Erfindung betrifft neben dem Verfahren auch eine Schaltungsanordnung zur Strommessung gemäß Anspruch 8.

In der erfindungsgemäßen Schaltungsanordnung ist im Signalpfad zur Messung des Stroms zumindest ein Tiefpass (11) zur Glättung des Stromsignals vorgesehen. Zur Wandlung des Strommesswertes ist zumindest ein A/D-Wandler (19) und zumindest ein Strommesselement (30, 30') vorhanden. Zumindest ein Endstufentreiber umfasst einen Ansteuerpfad und einen Rezirkulationspfad, wobei sowohl im Rezirkulationspfad als auch im Ansteuerpfad ein elektronisches Bauelement zur Strommessung vorgesehen ist.
Der im Rezirkulationspfad bestimmte Stromwert und der im Ansteuerpfad bestimmte Stromwert werden über ein Summenglied, wie insbesondere einen Schaltungsknotenpunkt oder ein digitales Summierglied, zu einem gemeinsamen Strom- oder Spannungssignal zusammengeführt.
Der Tiefpass kann entweder ein durch ein Analogfilter oder ein Digitalfilter realisiert sein, wobei je nach dem um welche Filterart es sich handelt, der Tiefpass im Strommesssignalpfad entweder vor oder nach dem A/D-Wandler angeordnet ist.

Weitere bevorzugte Ausführungsformen ergeben sich aus den Unteransprüchen und der nachfolgenden Beschreibung von Ausführungsbeispielen an Hand von Figuren.

Es zeigen
- Fig. 1: den Stromverlauf in einer PWM-geregelten induktiven Last bei einer Regelungsschaltung nach dem Stand der Technik,
- Fig. 2: nur eine PWM-Periode des Fig. 1 entsprechenden Stromverlaufs nach dem Stand der Technik,
- Fig. 3: eine schematische Darstellung einer Endstufenschaltung mit Rezirkulationspfad nach dem Stand der Technik,
- Fig. 4: eine Schaltungsanordnung zur Strommessung im Ansteuerpfad und Rezirkulationspfad,
- Fig. 5: ein Diagramm zur Darstellung der Glättung des Stromsignals I_{L} durch Tiefpassfilterung,
- Fig. 6: eine entsprechende Glättung des Stromsignals I_{L} durch Tiefpassfilterung bei zu niedriger Grenzfrequenz des Filters,
- Fig. 7: eine entsprechende Glättung des Stromsignals I_{L} durch Tiefpassfilterung mit dynamischer Anpassung der Grenzfrequenz des Filters,
- Fig. 8: ein Ausführungsbeispiel für eine Schaltungsanordnung mit Auto-Kalibrierungseinrichtung,
- Fig. 9 und 10: ein zweites Ausführungsbeispiel für eine Schaltungsanordnung mit Auto-Kalibrierungseinrichtung und zusätzlicher Bereichsanpassung.

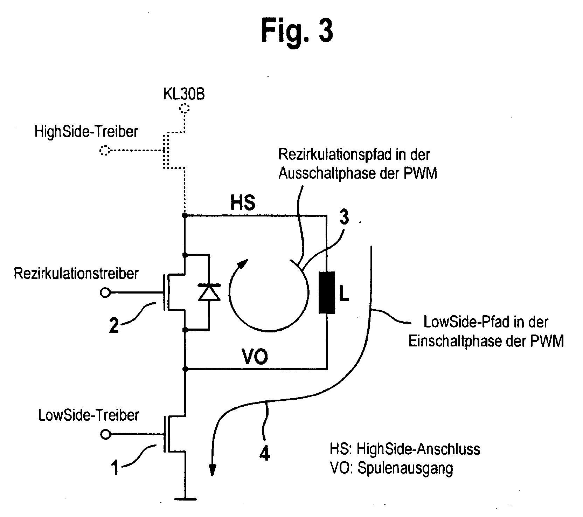

Die in Fig. 3 dargestellte schematisierte Darstellung einer Endstufenschaltung mit low side-Ansteuertreiber 1 und Rezirkulationstreiber 2 dient zur Erläuterung der dargestellten Ströme während einer PWM-Ansteuerung der induktiven Last L. Über low side-Treiber 1 wird Last L gegen Masse geschaltet, wodurch der Spulenstrom bei noch nicht erreichtem Maximalstrom exponentiell ansteigt. Im abgeschalteten Zustand der PWM-Ansteuerung ist Treiber 2 leitend, so dass der Abklingstrom der Spule über Rezirkulationspfad 3 fließen kann. Dies führt zu einem exponentiellen Abklingen des Stroms.

Gemäß einem Ausführungsbeispiel der Erfindung wird auch der Strom des Rezirkulations-Pfades 3 zur Messung des Iststroms der Stromregelung gemessen. Hierdurch ergibt sich der Vorteil, dass auch bei kürzeren Anschaltzeiten der PWM-Ansteuerung eine Strommessung möglich ist.

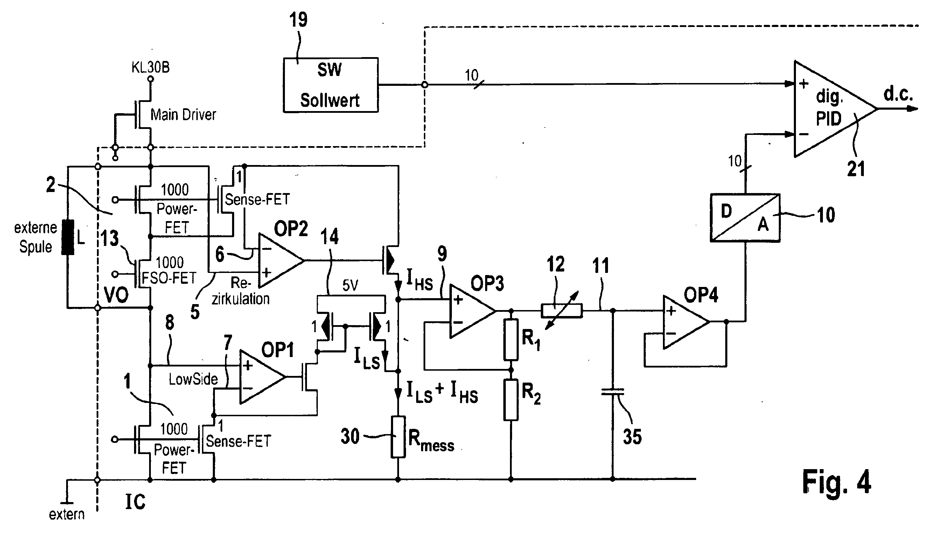

In der Schaltungsanordnung gemäß Fig. 4 wird das Strommesssignal 5, 6 des Rezirkulationstreibers 2 und das Strommesssignal 7, 8 des Ansteuertreibers 1 zu einem gemeinsamen Summensignal 9 zusammengeführt und über einen Tiefpass 11 geleitet. Eine aufwändige Priorisierungslogik für A/D-Wandler 10, welche die Reihenfolge bei der Auswertung mehrerer PWM-Stufen festlegt, kann somit entfallen. Tiefpass 11, 12 ist als Filter erster Ordnung bestehend aus trimmbarem Widerstand 12 und Kondensator 35 ausgeführt, wobei durch die Trimmbarkeit von Widerstand 12 die Zeitkonstante des Tiefpasses verändert werden kann.

Das Messen der Ströme im jeweiligen Leistungspfad 1 bzw. 2 erfolgt auf an sich bekannte Weise mittels Sense-FETs.
Sense-FETs stellen ein um mehrere Größenordnungen (z. B. Faktor 100 - 1000) reduziertes Abbild des Laststroms, der durch die Power-FETs fließt, zur Verfügung. Messstrom 5, 6 bzw. 7, 8 wird über Sense-Verstärker OP2 bzw. OP1 verstärkt. Der in Fig. 4 dargestellte FSD-FET 13 dient der schnelleren Absenkung des Stromes (Abkommutierung), wie dies in Patentanmeldung DE102004017239 (P 10676) erläutert ist. Mittels dieser an sich bekannten Stromabsenkung kann die Abklingzeit des Spulenstroms von ca. 10 ms auf ca. 1,5 ms verringert werden.

Die Ströme I_{LS} und I_{HS} stellen die Ströme des low side- bzw. Rezirkulationspfades dar. Die Summe der beiden Ströme I_{LS} + I_{HS} erzeugt einen Spannungsabfall an Messwiderstand Rₘₑₛₛ, der über Operationsverstärker OP3 verstärkt wird. Damit die Ströme I_{LS}, und I_{HS} den gleichen Richtungssinn aufweisen, wird der Strom aus dem low side-Messkreis über einen Stromspiegel 14 geführt. Über Operationsverstärker OP3 wird die an Rₘₑₛₛ abfallende Spannung verstärkt. Alternativ kann die Schaltung auch so ausgelegt werden, dass Verstärker OP3 als Spannungsfolger arbeitet.

Nach einem nicht dargestellten, alternativen Schaltungsbeispiel kann auch der gemessene low side-Strom direkt und der Rezirkulationsstrom über einen NMOS-Stromspiegel zusammengeführt werden. Allerdings ist hierzu erforderlich, dass Verstärker OP3 als invertierender Operationsverstärker mit dem Messwiderstand Rₘₑₛₛ in der Rückkopplungsleitung ausgeführt ist, wobei der positive Eingang auf ein Referenzpotenzial gelegt wird.

Da während des Betriebs der Schaltung immer nur entweder der Strom I_{LS} oder der Strom I_{HS} fließt, steht am Ausgang von Verstärker OP3 innerhalb einer PWM-Periode sowohl während der Anschalt- als auch während der Abschaltzeit ein im wesentlichen kontinuierliches Signal zur Verfügung.

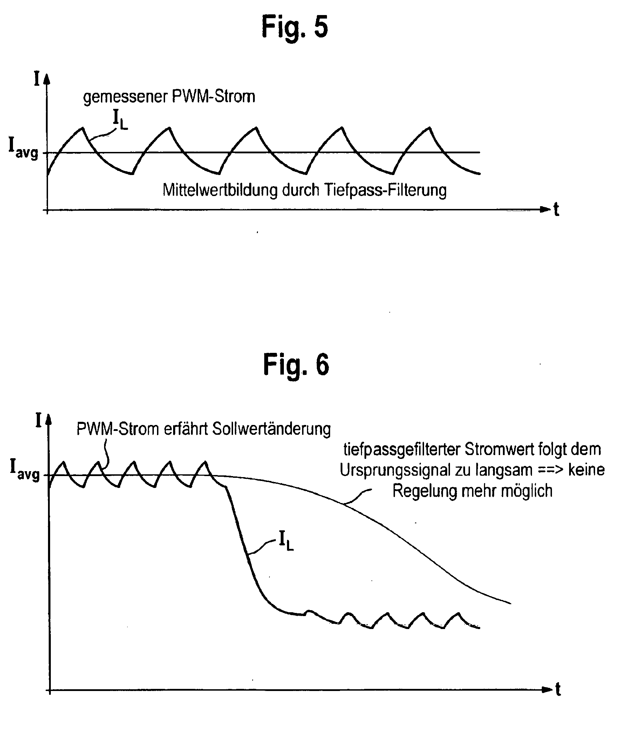

In Fig. 5 ist mit I_{L} das ausgangsseitig an Verstärker OP3 (Fig. 4) anliegende Spannungssignal im zeitlichen Verlauf bezeichnet. Da jedem Spannungswert ein bestimmter Stromwert zugeordnet ist, werden aus Gründen der Einfachheit die entsprechenden Spannungswerte als Ströme bezeichnet. I_{avg} bezeichnet das Signal, welches am Ausgang des Tiefpasses 11, 12 anliegt. In Fig. 5 ist erkennbar, dass das Signal I_{avg} noch eine kleine Restwelligkeit aufweist. Auf Grund der Induktivität der Last ist der Strom I_{L} starken Schwankungen unterworfen. Bei zeitdiskreten Messungen des Stroms ergeben sich zumindest dann, wenn die Messungen zu unterschiedlichen Zeitpunkten geschehen, unterschiedliche Strommesswerte. Durch Tiefpass 11, 12, dessen Grenzfrequenz anpassbar ist, wird das Signal I_{L} geglättet. Zeitdiskrete Strommessungen, denen das geglättete Signal I_{avg} zu Grunde gelegt wird, sind dann gegenüber Messungen am ungeglätteten Signal I_{L} erheblich genauer durchführbar.

In Fig. 6 ist beispielhaft ein sich vergleichsweise schnell ändernder Laststrom I_{L} dargestellt, bei dem das durch den Tiefpassfilter 12, 11 geleitete geglättete Stromsignal nicht mehr schnell genug folgt. In diesem Fall muss zur Sicherstellung einer funktionierenden PWM-Regelung die Zeitkonstante des Tiefpasses herabgesetzt werden. Eine entsprechend niedrige Zeitkonstante führt dann jedoch zu einer nicht vollständigen Glättung des Signals und schließlich zu einer gewissen Verringerung der Stromregelgenauigkeit. Die Grenzfrequenz kann zwar im Mittel so eingestellt werden, dass sich einerseits eine Signalglättung ergibt, andererseits das Stromsignal noch schnell genug auf Stromänderungen reagiert jedoch ist damit noch nicht die höchstmögliche Strommessgenauigkeit erreicht.

Durch Einsatz eines adaptiven Tiefpasses mit veränderbarer Grenzfrequenz kann unter Beibehaltung einer bauteilsparenden Schaltung zugleich eine gute Glättung als auch eine verbesserte Dynamik erreicht werden. Die Veränderung der Grenzfrequenz kann zum Beispiel durch Ansteuerung eines MOS-Transistors als steuerbaren Widerstand 12 erfolgen, welcher einen für den vorliegenden Einsatzzweck ausreichend linearen Widerstandsbereich besitzt. Alternativ kann an Stelle von Transistor 12 beispielsweise eine Switched-Capacitor-Schaltung eingesetzt werden, in der sich über eine zur Ansteuerung verwendete Hilfsfrequenz ein variabler Widerstand einstellen lässt.

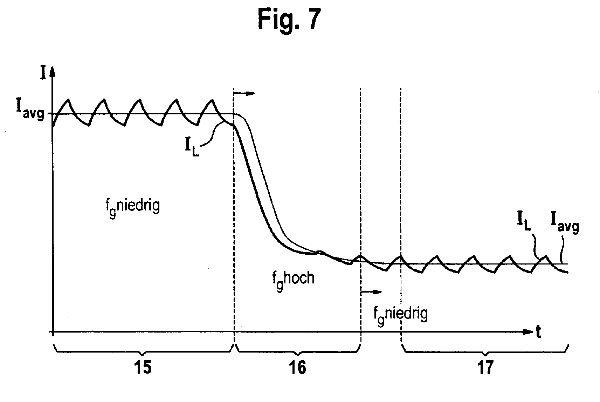

An Hand von Fig. 7 wird nachfolgend die Adaption der Grenzfrequenz des Filters erläutert. Soll ein konstanter Strom I_{L} im Zeitbereich 15 präzise eingeregelt werden, kann die Grenzfrequenz f_{g} des Tiefpasses auf einen vergleichsweise niedrigen Wert eingestellt werden. Wird der PWM-Regler durch eine neue Sollstromanforderung zu einer vergleichsweise schnellen Stromänderung (siehe Zeitbereich 16) veranlasst, wird die Grenzfrequenz des Tiefpasses so weit heraufgesetzt, dass eine ausreichende Dynamik gewährleistet ist. Bei Annäherung von Soll- und Istwert des Stromes (siehe Bereich 17) wird die Grenzfrequenz f_{g} sodann wieder - was erfindungsgemäß bevorzugt ist - sukzessive reduziert, um eine hohe Stromregelgenauigkeit zu erreichen.

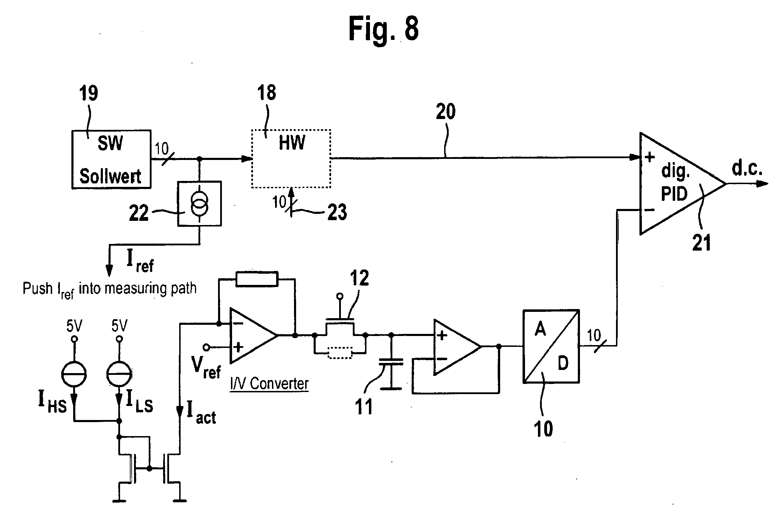

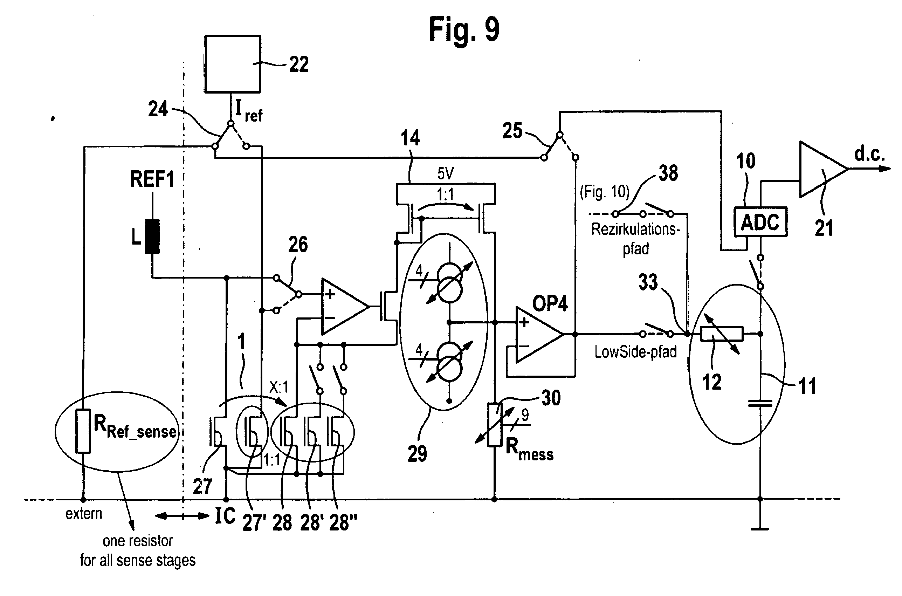

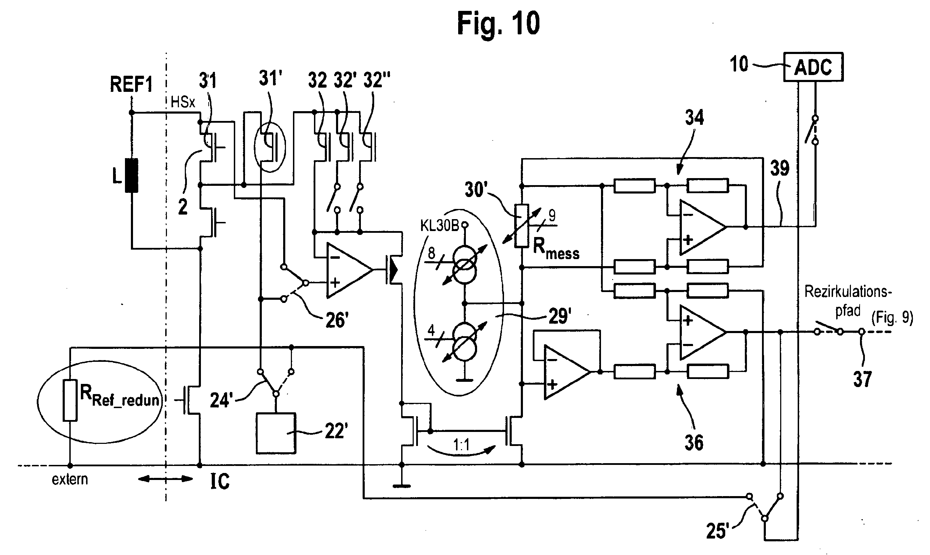

Die in Fig. 8 dargestellte Schaltung stellt ein Ausführungsbeispiel mit Auto-Kalibrierungseinrichtung dar und geht von dem Schaltungsbeispiel in Fig. 4 aus. Zusätzlich zur Schaltung in Fig. 4 ist eine digitale, also programmierbare Referenzstromquelle 22 vorhanden, mit der ein Referenzstrom I_{ref} erzeugt werden kann. I_{ref} wird über entsprechende Leitungen in den Strompfad der Last eingespeist, wobei der Strom außerdem über einen in Fig. 9 dargestellten Messwiderstand R_{Ref_sense} geführt ist. Da eine besondere Genauigkeit der Referenzstromquellen nicht erforderlich ist, können diese zweckmäßigerweise einfach aus in geeigneter Menge parallelgeschalteter elementarer Transistoren aufgebaut sein. Zur Bestimmung des durch die digitale Stromquelle erzeugten Stroms ist ein externer Messwiderstand (R_{ref_sense} in Fig. 9 bzw. R_{ref}__{redun} in Fig. 10) vorgesehen. "Extern" bedeutet hier, dass der Messwiderstand im Gegensatz zu den übrigen Schaltungsbauelementen nicht Bestandteil der integrierten Schaltung ist. Ein ebenfalls nicht dargestellter Spannungsabgriff an besagtem Messwiderstand wird A/D-Wandler 10 zugeführt. Weiterhin ist zusätzlich eine digitale Kompensationsstufe 18 vorhanden. Kompensationsstufe 18 umfasst einen Digitaleingang 23, mit dem ein von der Software vorgegebener Sollwert (symbolisiert durch Kasten 19) abhängig vom Digitaleingang korrigiert werden kann, z.B. indem ein Offsetwert digital addiert bzw. subtrahiert wird. Das offsetkompensierte Digitalsignal 20 gelangt dann in einen digitalen PID-Regler 21, welcher zur Generierung des duty cycle der PWM (d.c.) dient. Die Stromquellen I_{LS} bzw. I_{HS} symbolisieren den gemessenen low side- bzw. Rezirkulationsstrom. Wenn das am Ausgang des A/D-Wandlers auftretende digitale Ergebnis nicht mit dem erwarteten übereinstimmt, ist diese Abweichung ein Maß für den Fehler, der durch low side- bzw. Rezirkulationsmesspfad gemacht wird.

In der Schaltung entsprechend Fig. 8 wird zunächst ein Messstrom I_{ref} in den low side-Pfad und anschließend in den Rezirkulations-Pfad eingespeist und mittels der Strommessschaltung jeweils der Iststrom bestimmt. Durch Vergleich des Iststroms mit dem bekannten Messstrom I_{ref} wird ein Korrekturwert bestimmt, welcher in Form einer digitalen Korrektur in Kompensationsschaltung 18 zur Korrektur des Sollwerts 19 berücksichtigt wird. Werden die Vergleichsmessungen differentiell durchgeführt, kann hierbei vorteilhafterweise auch eine Berücksichtigung des A/D-Wandlerfehlers erfolgen. Die Kompensationsschaltung führt zu einer erheblich präziseren Stromeinstellung bei der PWM-Regelung, insbesondere dann, wenn durch entsprechende Einspeisung des Messstroms I_{ref} jeder Messpfad separat in seiner Qualität bewertet wird. Dies kann besonders einfach dadurch erfolgen, dass der Messstrom zugleich den low side-Pfad und den Rezirkulations-Pfad durchläuft. Ein weiterer Vorteil der vorstehend beschriebenen Kompensationsschaltung besteht darin, dass preiswertere Analog-IC's mit geringerer Präzision eingesetzt werden können.

Die in Fig. 9 und 10 dargestellte Schaltung stellt ein zweites Ausführungsbeispiel mit Auto-Kalibrierungseinrichtung dar, wobei aus Gründen der vereinfachten Darstellung in Fig. 9 die Schaltungsteile für den low side-Pfad und in Fig. 10 die Schaltungsteile für den Rezirkulations-Pfad dargestellt sind. Die Schaltung ähnelt der Schaltung in Fig. 8 und Fig. 4, so dass nachfolgend nur auf die bestehenden Unterschiede eingegangen wird. Im Gegensatz zur Stromsummation in Fig. 4 wird bei dem Konzept gemäß Fig. 9 und 10 der Strommesswert des low side-Pfads und des Rezirkulationspfads über ein Spannungssignal miteinander verknüpft (Knotenpunkt 33). Prinzipiell kann an Stelle der beispielgemäßen analogen Signalverarbeitung auch eine Verarbeitung von Digitaldaten erfolgen. In diesem Fall wäre die Verknüpfung zweckmäßigerweise mittels eines digitalen Summenglieds zu realisieren. Mit Schalter 24 (24' in Fig. 10) kann der Referenzstrom I_{ref}, der von Referenzstromquelle 22 (22' in Fig. 10) eingespeist wird, über Messwiderstand R_{Ref_Sense} (R_{Ref_redun} in Fig. 10) oder durch den low side-Pfad 1 (Rezirkulationspfad 2 in Fig. 10) geleitet werden. Entsprechend wird mittels Schaltern 25 und 26 (25' und 26' in Fig. 10) der Eingang des A/D-Wandlers 10 entweder mit R_{Ref}_ₛₑₙₛₑ oder dem low side-Pfad 1 verbunden. Die Anordnung aus Leistungs-FET 27 (31 in Fig. 10) und Sense-FET 28 (32 in Fig. 10) im low side-Pfad 1 umfasst zusätzliche Verstärkerstufen 27' und 28', welche eine Anpassung des Messbereichs erlauben (siehe Beschreibung weiter unten). Der Offset lässt sich mit Offset-Kompensationsstufe 29 (29' in Fig. 10) kompensieren, welche mit dem Eingang des Operationsverstärkers OP4 verbunden ist. In Fig. 10 ist der Ausgang der Kompensationsstufe 29' mit ähnlich wirkenden weiteren Differenz-Verstärkerstufen 34, 36 verbunden, die weiter unten noch näher erläutert werden. Am Ausgang 37 von Verstärkerstufe 36 steht ein analoges Stromsignal für den Rezirkulations-Pfad zur Verfügung, welcher mit Klemme 38 in Fig. 9 verbunden ist.

Auf welche Weise die einzelnen Messpfade des low side-Pfads und des Rezirkulationspfads durch den Einsatz von trimmbaren Stromquellen und Widerständen abgeglichen werden können, wird nachfolgend beschrieben. Genauer gesagt bedeutet dies, dass die Referenzstrommessungen jeweils für den low side-Pfad und den Rezirkulationspfad eigens durchgeführt werden müssen. Zunächst wird ein definierter Strom über R_{Ref_sense} (Fig. 9) geleitet. Dabei befinden sich die Schalter 24 und 25 in der in Fig. 9 durchgezogen gezeichneten Stellung. I_{Ref} wird mittels A/D-Wandler 10 ausgelesen. Dann wird dieser definierte Strom auch an FET 27' angelegt. Schalter 24, 25 und 26 befinden sich nun in der gestrichelt dargestellten Schalterstellung. Der durch Sense-FET 28 fließende Strom wird mittels A/D-Wandler 10 ausgelesen. Anschließend werden die obigen Messungen mit einem geringeren Strom noch einmal wiederholt. Entsprechend der mit verschiedenen Referenzströmen durchgeführten Messungen wird eine Verstärkungs-Trimmung über einen digitalen Trimmwiderstand 30 (30' in Fig. 10) in Fig. 4 vorgenommen. Des Weiteren erfolgt eine Offset-Trimmung mit Schaltungsteil 29.

Bevorzugt werden die oben beschriebenen Kalibrierungsschritte sowohl für den low side- (Fig. 9) als auch für den Rezirkulationspfad (Fig. 10) iterativ durchgeführt, wobei sich mit zunehmender Zahl von Schritten die Genauigkeit bestehend aus Offset und Verstärkungsfaktor schrittweise erhöht. Nach ein paar wenigen Iterationsschritten kann das Verfahren in der Regel bereits abgebrochen werden, da sich die Genauigkeit des iterativen Verfahrens dann nur noch in geringem Maße erhöht.

Die obigen Schaltungsbeispiele betreffen jeweils einen Lastansteuerungskanal einer mehrkanaligen PWM-Endstufe. Teile der Schaltungen, wie etwa der externe Messwiderstand R_{Ref_Sense} sind jedoch nur einmal vorhanden und werden durch jeden Kanal der Stufe verwendet. Entsprechend müssen die Referenzstrommessungen, die den externen Messwiderstand betreffen, lediglich einmal durchgeführt werden. Alle weiteren Kalibriermessungen müssen für jeden Endstufenkanal gesondert durchgeführt werden.

Die oben beschriebene Kalibriermethode kann auch zu späteren Zeitpunkten - auch während der Regelung - wiederholt bzw. fortgesetzt werden unter der Voraussetzung, dass der betreffende zu kalibrierende Kanal zu dieser Zeit nicht durch die PWM-Ansteuerung angesteuert wird.

Die Schaltungsbeispiele in Figuren 9 und 10 umfassen neben den FETs 27, 28, 31 und 32 außerdem noch zusätzliche Schaltungsmittel 28, 28', 28'', 32, 32' und 32" zur Erhöhung der Auflösung im aktiven Strombereich. Bei einem 10 Bit A/D-Wandler ist die Auflösung über einen Bereich von 3 A auf ca. 3 mA begrenzt. Eine höhere Auflösung kann durch eine Beschränkung des messbaren Strombereichs auf einen bestimmten, benötigten Dynamikbereich erreicht werden. So ist z.B. mit der in Fig. 8 bzw. Fig. 9 gezeigten Schaltung durch das separate Hinzuschalten gleichgroßer Sense-FETs 28' und 32' eine Umschaltung zwischen 1 A, 2 A und 3 A messbarem Maximalstrom möglich. Entsprechend ergibt sich eine mögliche Auflösung von 1 bis 3 mA im jeweiligen Bereich.

Die Auswahl des Strommessbereichs kann durch Logik erfolgen, z.B. durch Berücksichtigung des aktuellen Sollwertes des Stroms.

Entsprechend kann die Auflösung des A/D-Wandlers auch dadurch besser ausgenutzt werden, indem ein geeigneter Offset-Wert zunächst subtrahiert und später, nach der A/D-Wandlung, wieder addiert wird.

Zusätzlich ist es möglich, nach einem weiteren Beispiel für eine erfindungsgemäße Schaltungsanordnung diese mit Fail-Safe Strukturen 34 so zu erweitern, dass ein redundantes Stromsignal zur Verfügung steht. Es ist dabei besonders zweckmäßig, wenn A/D-Wandler 10 ein gegenüber dem anderen Redundanz-Pfad (Differenz-Verstärkerstufe 36 bestehend aus Spannnungsfolger-OP und nachgeschaltetem Differenz-OP) invertiertes (siehe Differenzverstärker 34) oder geändertes Messsignal an Leitung 39 zur Verfügung gestellt wird, wodurch die A/D-Wandlung überprüft werden kann.

## Patentansprüche

1. Verfahren, bei dem eine Strommessung innerhalb einer integrierten PWM-Regelungsschaltung mittels zumindest einem A/D-Wandler (10) durchgeführt wird, welcher ebenfalls in der Schaltung integriert ist, wobei die PWM-Regelung zur Ansteuerung von induktiven Lasten vorgesehen ist und diese insbesondere in einer elektronischen Schaltung eines elektronischen Reglers für ein Kraftfahrzeugbremssystem angeordnet ist, **dadurch gekennzeichnet, dass** vor dem Ermitteln des Iststroms der PWM-Regelung, welcher mit Hilfe des zumindest einen A/D-Wandler bestimmt wird, der Strom mittels eines Tiefpasses (11, 12) geglättet wird, wobei die obere Grenzfrequenz des Tiefpasses oder dessen Zeitkonstante veränderbar ist und diese in Abhängigkeit des PWM-Sollstroms oder der PWM-Sollstromänderung verändert wird.

2. Verfahren nach Anspruch 1, **dadurch gekennzeichnet, dass** die Glättung des Stroms mittels einer Tiefpassschaltung erster oder höherer Ordnung erfolgt.

3. Verfahren nach Anspruch 1 oder 2, **dadurch gekennzeichnet, dass** die obere Grenzfrequenz oder die Zeitkonstante des Tiefpasses so gewählt wird, dass die obere Grenzfrequenz der induktiven Last nicht unterschritten bzw. deren Zeitkonstante nicht überschritten wird.

4. Verfahren nach mindestens einem der Ansprüche 1 bis 3,
**dadurch gekennzeichnet, dass** eine Autokalibrierung zur Erhöhung der Strommessgenauigkeit durchgeführt wird, indem zunächst für eine bestimmte Zeit ein Referenzstrom durch den Strompfad der Lastansteuerung und/oder in den Strompfad der Rezirkulation geleitet wird und auf Basis des in dieser Zeit gemessenen Stromsignals ein oder mehrere Korrekturwerte ermittelt wird/werden.

5. Verfahren nach Anspruch 4, **dadurch gekennzeichnet, dass** der oder die PWM-Treiber einen Schaltpfad und einen Rezirkulationspfad besitzen und der Referenzstrom sowohl durch den Rezirkulationspfad als auch durch den Ansteuerpfad geführt wird, wobei insbesondere jeweils für beide Pfade eigene Korrekturwerte gebildet und verwendet werden.

6. Verfahren nach Anspruch 4 oder 5, **dadurch gekennzeichnet, dass** ein Referenzstrom über das Bauelement zur Strommessung geleitet wird und am Ausgang des mit dem Strommessbauelement verbundenen A/D-Wandlers dieser für die Erstellung von mindestens einem Korrekturwert für die Autokalibrierung genutzt wird.

7. Verfahren nach Anspruch 4, 5 oder 6, **dadurch gekennzeichnet, dass** der oder die ermittelten Korrekturwerte zur Korrektur des Iststroms und/oder zur Korrektur des Sollstroms herangezogen wird/werden, und dass nach der Autokalibrierung bei der Strommessung der oder die ermittelten Korrekturwerte zur Korrektur des gemessenen Stromsignals oder zur Korrektur des Sollwerts der PWM-Regelung herangezogen wird/werden.

8. Schaltungsanordnung in einem elektronischen Regler für Kraftfahrzeugbremssysteme mit einer in einem integrierten Schaltkreis angeordneten mehrkanaligen PWM-Endstufe zur Ansteuerung von induktiven Lasten, wobei zumindest ein Endstufentreiber einen Ansteuerpfad und einen Rezirkulationspfad umfasst, wobei sowohl im Rezirkulationspfad als auch im Ansteuerpfad ein elektronisches Bauelement zur Strommessung vorgesehen ist und wobei zur Messung des Iststroms, welcher durch eine induktive Last fließt, zumindest ein A/D-Wandler eingesetzt wird, welcher ebenfalls im integrierten Schaltkreis integriert ist, **dadurch gekennzeichnet, dass** der im Rezirkulationspfad bestimmte Stromwert und der im Ansteuerpfad bestimmte Stromwert über ein Summenglied, wie einen Schaltungsknotenpunkt (33), zu einem gemeinsamen Strom- oder Spannungssignal zusammengeführt werden, und dass im Signalpfad zur Messung des Stroms ein Tiefpass (11) zur Glättung des Stromsignals vorhanden ist.

9. Schaltungsanordnung nach Anspruch 8, **dadurch gekennzeichnet, dass** der Tiefpass ein analoger Tiefpass erster, zweiter oder höherer Ordnung ist.

10. Schaltungsanordnung nach Anspruch 8 oder 9, **dadurch gekennzeichnet, dass** der Tiefpass mit diskreten Bauelementen außerhalb der integrierten Schaltung und/oder mittels Switched-Capacitor Technik innerhalb des bzw. eines integrierten Schaltkreises realisiert ist.

11. Schaltungsanordnung nach mindestens einem der Ansprüche 8 bis 10, **dadurch gekennzeichnet, dass** der Schaltkreis zur Messung des Stroms zumindest ein Widerstandsbauelement umfasst, wobei der Strom über den Spannungsabfall bestimmt wird.

12. Schaltungsanordnung nach mindestens einem der Ansprüche 8 bis 11, **dadurch gekennzeichnet, dass** der Schaltkreis zur Messung des Stroms zumindest einen Sense-FET umfasst.

13. Schaltungsanordnung nach mindestens einem der Ansprüche 8 bis 12, **dadurch gekennzeichnet, dass** der Rezirkulationspfad aktiv geschaltet wird.

14. Schaltungsanordnung nach mindestens einem der Ansprüche 8 bis 13, **dadurch gekennzeichnet, dass** entweder das vom Rezirkulationspfad oder vom Ansteuerpfad bestimmte Stromsignal vor dem Zusammenführen über einen Stromspiegel geführt wird, so dass beide aus den verschiedenen Pfaden bestimmte Stromsignale die gleiche Stromrichtung aufweisen.

15. Schaltungsanordnung nach mindestens einem der Ansprüche 8 bis 14, **dadurch gekennzeichnet, dass** die PWM-Endstufe hinsichtlich des Stromoffsets und/oder des Verstärkungsfaktors mittels Korrekturwerten kalibrierbar ist, wobei die Korrekturwerte insbesondere nach dem Verfahren gemäß mindestens einem der Ansprüche 4 bis 7 ermittelt werden.

16. Schaltungsanordnung nach mindestens einem der Ansprüche 8 bis 15, **dadurch gekennzeichnet, dass** eine Bereichsumschaltung für den/die A/D-Wandler vorhanden ist, so dass der/die A/D-Wandler, welche/r durch eine feste Bit-Anzahl für einen bestimmten, vorgegebenen Strombereich eine bestimmte Auflösung besitz-t/-en, durch eingangsseitige Begrenzung des Strombereichs mit einer höheren Stromauflösung betrieben werden kann/können.

17. Schaltungsanordnung nach Anspruch 16, **dadurch gekennzeichnet, dass** die Bereichsumschaltung durch eine Logik automatisch vorgenommen wird, insbesondere in Abhängigkeit des Sollstromes und vorgegebenen Sollstrombereichen.

18. Schaltungsanordnung nach Anspruch 16 oder 17, **dadurch gekennzeichnet, dass** neben der Bereichsumschaltung Schaltungselemente zur Offsetsubtraktion vorhanden sind, mit denen eine Erhöhung der nutzbaren A/D-Wandler-Auflösung erreicht wird.

19. Verwendung der Schaltungsanordnung nach mindestens einem der Ansprüche 8 bis 18 in einem Regler für elektronische Kraftfahrzeugbremssysteme, bei dem elektromagnetische Hydraulikventile über PWM-Endstufen zur Einstellung des Hydraulikdrucks innerhalb der Radbremsen des Kraftfahrzeugs genutzt werden.

## Claims

1. Method in which the current within an integrated PWM control circuit is measured by means of at least one A/D converter (10) which is also integrated into the circuit, wherein the PWM controller is provided for driving inductive loads, and said PWM controller is arranged, in particular, in an electronic circuit of an electronic controller for a motor vehicle brake system, **characterized in that**, before the actual current of the PWM controller is acquired, said current being determined using the at least one A/D converter, the current is smoothed by means of a low pass filter (11, 12), wherein the upper cutoff frequency of the low pass filter or its time constant can be varied, and said time constant is varied as a function of the PWM setpoint current or of the change in the PWM setpoint current.

2. Method according to Claim 1, **characterized in that** the smoothing of the current is carried out by means of a low pass circuit of the first or of a higher order.

3. Method according to Claim 1 or 2, **characterized in that** the upper cutoff frequency or the time constant of the low pass filter is selected in such a way that the upper cutoff frequency of the inductive load is not undershot and/or its time constant is not exceeded.

4. Method according to at least one of Claims 1 to 3, **characterized in that** auto-calibration is carried out in order to increase the current measuring accuracy, **in that** firstly a reference current is directed through the current path of the load driving means for a specific time and/or into the recirculation current path, and one or more correction values is/are acquired on the basis of the current signal measured in this time.

5. Method according to Claim 4, **characterized in that** the PWM driver or drivers has/have a switching path and a recirculation path, and the reference current is fed both through the recirculation path and through the driving path, wherein, in particular, separate correction values are respectively formed and used for the two paths.

6. Method according to Claim 4 or 5, **characterized in that** a reference current is directed via the component for measuring current, and at the output of the A/D converter which is connected to the current measuring component said A/D converter is used to produce at least one correction value for the auto-calibration.

7. Method according to Claim 4, 5 or 6, **characterized in that** the correction value or values which is/are acquired is/are used to correct the actual current and/or to correct the setpoint current, and **in that**, after the auto-calibration during the measurement of current the correction value or values which is/are acquired is/are used to correct the measured current signal or to correct the setpoint value of the PWM controller.

8. Circuit arrangement in an electronic controller for motor vehicle brake systems having a multi-channel PWM output stage which is arranged in an integrated circuit and has the purpose of driving inductive loads, at least one output stage driver comprises a driving path and a recirculation path, wherein an electronic component for measuring current is provided both in the recirculation path and in the driving path and wherein, in order to measure the actual current which flows through an inductive load, at least one A/D converter which is also integrated into the integrated circuit is used, **characterized in that** the current value which is determined in the recirculation path and the current value which is determined in the driving path are combined by means of a summing element such as a circuit node point (33), to form a common current signal or voltage signal, and **in that** a low pass filter (11) which has the purpose of smoothing the current signal is present in the signal path for measuring the current.

9. Circuit arrangement according to Claim 8, **characterized in that** the low pass filter is an analog low pass filter of the first, second or a higher order.

10. Circuit arrangement according to Claim 8 or 9, **characterized in that** the low pass filter is implemented with discrete components outside the integrated circuit and/or by means of a switched capacitor technology within the integrated circuit or an integrated circuit.

11. Circuit arrangement according to at least one of Claims 8 to 10, **characterized in that** the circuit for measuring the current comprises at least one resistance component, wherein the current is determined by means of the drop in voltage.

12. Circuit arrangement according to at least one of Claims 8 to 11, **characterized in that** the circuit for measuring the current comprises at least one sense FET.

13. Circuit arrangement according to at least one of Claims 8 to 12, **characterized in that** the recirculation path is switched actively.

14. Circuit arrangement according to at least one of Claims 8 to 13, **characterized in that** either the current signal which is determined by the recirculation path or the current signal which is determined by the driving path is fed in via a current mirror before combination so that both current signals which are determined from the various paths have the same current direction.

15. Circuit arrangement according to at least one of Claims 8 to 14, **characterized in that** the PWM output stage can be calibrated in terms of the current offset and/or the gain factor by means of correction values, wherein the correction values are acquired, in particular, according to the method according to at least one of Claims 4 to 7.

16. Circuit arrangement according to at least one of Claims 8 to 15, **characterized in that** a range switching means is provided for the A/D converter or converters so that the A/D converter or converters which has/have a specific resolution as a result of a fixed bit number for a specific, predefined current range can be operated through input-side limitation of the current range with a relatively high current resolution.

17. Circuit arrangement according to Claim 16, **characterized in that** the range switching is performed automatically by means of a logic means, in particular as a function of the setpoint current and predefined setpoint current ranges.

18. Circuit arrangement according to Claim 16 or 17, **characterized in that**, in addition to the range switching, switching elements are provided for offset subtraction, with which elements an increase in the usable A/D converter resolution is achieved.

19. Use of the circuit arrangement according to at least one of Claims 8 to 18 in a controller for electronic motor vehicle brake systems, in which electromagnetic hydraulic valves are used, by means of PWM output stages, for setting the hydraulic pressure within the wheel brakes of the motor vehicle.

## Revendications

1. Procédé selon lequel une mesure de courant est réalisée à l'intérieur d'un circuit de régulation PWM intégré au moyen d'au moins un convertisseur A/N (10), lequel est lui aussi intégré dans le circuit, la régulation PWM étant prévue pour commander des charges inductives et celle-ci étant notamment disposée dans un circuit électronique d'un régulateur électronique pour un système de freinage de véhicule automobile, **caractérisé en ce qu'**avant de déterminer le courant réel de la régulation PWM, lequel est déterminé à l'aide de l'au moins un convertisseur A/N, le courant est lissé au moyen d'un filtre passe-bas (11, 12) la fréquence limite supérieure du filtre passe-bas ou sa constante de temps pouvant être modifiée et celle-ci étant modifiée en fonction du courant de consigne PWM ou de la variation du courant de consigne PWM.

2. Procédé selon la revendication 1, **caractérisé en ce que** le lissage du courant est réalisé au moyen d'un circuit de filtrage passe-bas du premier ordre ou d'un ordre supérieur.

3. Procédé selon la revendication 1 ou 2, **caractérisé en ce que** la fréquence limite supérieure ou la constante de temps du filtre passe-bas est choisie de telle sorte que la fréquence limite supérieure de la charge inductive n'est pas franchie vers le bas ou sa constante de temps n'est pas franchie vers le haut.

4. Procédé selon au moins l'une des revendications 1 à 3, **caractérisé en ce qu'**un calibrage automatique est effectué pour augmenter la précision de mesure du courant, **en ce qu'**un courant de référence est tout d'abord mis à circuler pendant un certain temps à travers le trajet du courant de la commande de charge et/ou dans le trajet du courant de recirculation et une ou plusieurs valeurs de correction est/sont déterminée(s) en se basant sur le signal de courant mesuré pendant cette période.

5. Procédé selon la revendication 4, **caractérisé en ce que** le ou les circuits d'attaque PWM possèdent un trajet de commutation et un trajet de recirculation et le courant de référence est acheminé à la fois à travers le trajet de recirculation et à travers le trajet de commande, des valeurs de correction propres étant notamment respectivement calculées et utilisées pour les deux trajets.

6. Procédé selon la revendication 4 ou 5, **caractérisé en ce qu'**un courant de référence est acheminé par le biais du composant pour la mesure du courant et celui-ci est utilisé à la sortie du convertisseur A/N relié au composant de mesure du courant pour la création d'au moins une valeur de correction pour le calibrage automatique.

7. Procédé selon la revendication 4, 5 ou 6, **caractérisé en ce que** la ou les valeurs de correction déterminées est/sont utilisée(s) pour la correction du courant réel et/ou pour la correction du courant de consigne, et **en ce que** la ou les valeurs de correction déterminée(s) est/sont utilisée(s) après le calibrage automatique lors de la mesure du courant pour la correction du signal de courant mesuré ou pour la correction de la valeur de consigne de la régulation PWM.

8. Arrangement de circuit dans un régulateur électronique pour systèmes de freinage de véhicule automobile, comprenant un étage final PWM à plusieurs canaux disposé dans un circuit intégré pour commander des charges inductives, au moins un circuit d'attaque d'étage final comprenant un trajet de commande et un trajet de recirculation, un composant électronique de mesure du courant étant prévu à la fois dans le trajet de recirculation et dans le trajet de commande et au moins un convertisseur A/N, lequel est lui aussi intégré dans le circuit intégré, étant utilisé pour mesurer le courant réel qui circule à travers une charge inductive, **caractérisé en ce que** la valeur du courant déterminée dans le trajet de recirculation et la valeur du courant déterminée dans le trajet de commande sont réunies en un signal de courant ou de tension commun par le biais d'un additionneur, comme un point nodal de commutation (33),
et **en ce qu'**un filtre passe-bas (11) destiné à lisser le signal de courant est présent dans le trajet du signal de mesure du courant.

9. Arrangement de circuit selon la revendication 8, **caractérisé en ce que** le filtre passe-bas est un filtre passe-bas analogique du premier ou du deuxième ordre ou d'un ordre supérieur.

10. Arrangement de circuit selon la revendication 8 ou 9, **caractérisé en ce que** le filtre passe-bas est réalisé avec des composants discrets en-dehors du circuit intégré et/ou au moyen d'une technique de condensateurs commutés à l'intérieur du ou d'un circuit intégré.

11. Arrangement de circuit selon au moins l'une des revendications 8 à 10, **caractérisé en ce que** le circuit comprend au moins un composant résistif pour la mesure du courant, le courant étant déterminé par le biais de la chute de tension.

12. Arrangement de circuit selon au moins l'une des revendications 8 à 11, **caractérisé en ce que** le circuit comprend au moins un FET de détection pour la mesure du courant.

13. Arrangement de circuit selon au moins l'une des revendications 8 à 12, **caractérisé en ce que** le trajet de recirculation est commuté activement.

14. Arrangement de circuit selon au moins l'une des revendications 8 à 13, **caractérisé en ce que** le signal de courant déterminé par le trajet de recirculation ou par le trajet de commande est acheminé à un miroir de courant avant d'être réunis, de sorte que les deux signaux de courant déterminés à partir des deux trajets présentent le même sens de courant.

15. Arrangement de circuit selon au moins l'une des revendications 8 à 14, **caractérisé en ce que** le décalage en courant et/ou le facteur d'amplification des étages finaux PWM peuvent être calibrés au moyen de valeurs de correction, les valeurs de correction étant notamment déterminées d'après le procédé selon au moins l'une des revendications 4 à 7.

16. Arrangement de circuit selon au moins l'une des revendications 8 à 15, **caractérisé en ce qu'**il existe une commutation de plage pour le/les convertisseur(s) A/N, de sorte que le/les convertisseur(s) A/N, qui possède(nt) une résolution déterminée par un nombre fixe de bits pour une plage de courant donnée prédéfinie, peut/peuvent fonctionner avec une résolution de courant supérieure par une limitation de la plage de courant à l'entrée.

17. Arrangement de circuit selon la revendication 16, **caractérisé en ce que** la commutation de plage est effectuée automatiquement par un circuit logique, notamment en fonction du courant de consigne et de plages de courant de consigne prédéfinies.

18. Arrangement de circuit selon la revendication 16 ou 17, **caractérisé en ce qu'**en plus de la commutation de plage, il existe des éléments de commutation de soustraction du décalage qui permettent d'obtenir un accroissement de la résolution utilisable du convertisseur A/N.

19. Utilisation de l'arrangement de circuit selon au moins l'une des revendications 8 à 18 dans un régulateur pour systèmes électroniques de freinage de véhicule automobile, selon laquelle des vannes hydrauliques électromagnétiques sont utilisées par le biais d'étages finaux PWM pour régler la pression hydraulique à l'intérieur des freins de roue du véhicule automobile.
